# EUROPEAN PATENT SPECIFICATION

(11) **EP 2 971 225 B1**
(45) Date of publication and mention of the grant of the patent: **22.02.2017**
(21) Application number: 13711867.5
(22) Date of filing: 15.03.2013
(51) Int. Cl.: C23C 14/50, C03C 17/00

(54) **CARRIER FOR A SUBSTRATE AND METHOD FOR CARRYING A SUBSTRATE**
SUBSTRATTRÄGER UND VERFAHREN ZUM TRAGEN EINES SUBSTRATS
SUPPORT POUR UN SUBSTRAT ET PROCÉDÉ POUR SOUTENIR UN SUBSTRAT

(43) Date of publication of application: 20.01.2016
(73) Proprietor: Applied Materials, Inc., Santa Clara, CA 95054 (US)
(72) Inventor: HINTERSCHUSTER, Reiner, 63546 Hammersbach (DE); BRÜNING, Andre, 63811 Stockstadt (DE)
(74) Representative: Zimmermann & Partner Patentanwälte mbB
(86) International application number: PCT/EP2013/055457
(87) International publication number: WO 2014/139594

(56) References cited:
- EP-A1- 1 998 366
- EP-A1- 2 423 350
- JP-A- H1 072 668

## Description

### TECHNICAL FIELD

Embodiments relate to a carrier for a substrate to be coated and a method for carrying a substrate to be coated. Embodiments of the present invention particularly relate to the frame of the substrate carrier, specifically to holding means for the substrate in the carrier.

### BACKGROUND

Several methods are known for depositing a material on a substrate. For instance, substrates may be coated by a physical vapor deposition (PVD) process, a chemical vapor deposition (CVD) process, a plasma enhanced chemical vapor deposition (PECVD) process etc. Typically, the process is performed in a process apparatus or process chamber, where the substrate to be coated is located or guided through. A deposition material is provided in the apparatus. A plurality of materials, among them oxides, nitrides, carbides, or metals may be used for deposition on a substrate. Further, other processing steps like etching, structuring, annealing, or the like can be conducted in processing chambers.

Coated materials may be used in several applications and in several technical fields. For instance, an application lies in the field of microelectronics, such as generating semiconductor devices. Also, substrates for displays are often coated by a PVD process. Further applications, especially for coated glass substrates, are color filters (CF) and touch panels (TP) for liquid crystal (flat panel) displays (LCD). Yet further applications include insulating panels, organic light emitting diode (OLED) panels, substrates with TFT, or the like.

Within recent years, the substrates used are increased in size. Especially glass substrates to be coated make handling, supporting and processing of the substrates challenging without sacrificing the throughput by glass breakage.

Typically, glass substrates can be supported on carriers during processing thereof. A carrier drives the glass or the substrate through the processing machine. The carriers typically form a frame, which supports a surface of the substrate along the periphery thereof. Particularly, a frame shaped carrier can also be used to mask a glass substrate, wherein the aperture in the carrier, which is surrounded by the frame, provides an aperture for coating material to be deposited on the exposed substrate portion.

EP 1 998 366 A discloses a frame for supporting a large-area glass substrate in which the substrate is fixedly attached at one corner of the frame. JP 10-72668 A shows another arrangement in which a substrate is clamped into a vertically oriented frame.

While the edge exclusion is desired to be as small as possible, it is nevertheless desired to have an existing edge exclusion, in particular an edge exclusion allowing precise and uniform coating of the substrate. However, the area of the substrate excluded by the edge exclusion depends inter alia on the thermal expansion of all involved materials, such as the substrate material and the carrier material, on the temperatures used, as well as on the inaccuracy of the substrate positioning inside the carrier due to automation robotics.

In view of the above, it is an object of embodiments described herein to provide a carrier for a substrate to be coated, which provides an optimized and reliable edge exclusion and prevents at the same time a breakage of the substrate during transport in the carrier.

### SUMMARY

In light of the above, a carrier for carrying a substrate and a method for carrying a substrate according to the independent claims are provided. Further aspects, advantages, and features are apparent from the dependent claims, the description, and the accompanying drawings.

According to one embodiment, a carrier for carrying a substrate in a deposition chamber is provided. The carrier includes a frame for vertically holding the substrate, wherein the frame has a substantially rectangular shape with a bottom frame part; and a fixing means for firmly fixing the substrate to the carrier, wherein the fixing means is located in a center region of the bottom frame part. The carrier further includes one or more support members for supporting but not firmly fixing the substrate.

According to another embodiment, a carrier for carrying a substrate in a deposition chamber is provided. The carrier includes a frame for vertically holding the substrate, wherein the frame has a substantially rectangular shape with a bottom frame part; and one single fixing means for firmly fixing the substrate to the carrier, wherein the fixing means is located in a center region of the bottom frame part. The carrier further includes one or more support members for supporting but not firmly fixing the substrate.

According to a further aspect, a method for carrying a substrate during a deposition process in a deposition chamber with a carrier is provided. The carrier includes a frame for vertically holding the substrate. The frame has a substantially rectangular shape with a bottom frame part. The method includes firmly fixing the substrate to the carrier with a fixing means at a center region of the bottom frame part; and supporting the substrate in the carrier by one or more support members without firmly fixing the substrate by the support members.

Embodiments are also directed at apparatuses for carrying out the disclosed methods and include apparatus parts for performing each described method step. The method steps may be performed by way of hardware components, a computer programmed by appropriate software, by any combination of the two or in any other manner. Furthermore, embodiments are also directed at methods by which the described apparatus operates. It includes method steps for carrying out every function of the apparatus.

### BRIEF DESCRIPTION OF THE DRAWINGS

So that the manner in which the above recited features can be understood in detail, a more particular description, briefly summarized above, may be had by reference to embodiments. The accompanying drawings relate to embodiments and are described in the following:
- Fig. 1a: shows a side view of a carrier and a substrate to be coated according to the state of the art;
- Fig. 1b: shows a detailed view of a section of the carrier and the substrate shown in Fig. 1a;
- Fig. 1c: shows a sectional view along line A-A of the carrier and the substrate shown in Fig. 1a;
- Fig. 2a: shows a schematic side view of a carrier according to embodiments described herein;
- Fig. 2b: shows a sectional view along line B-B of the carrier according to embodiments described herein shown in Fig. 2a;
- Fig. 3: shows a schematic side view of parts of a carrier according to embodiments described herein;
- Fig. 4: shows a schematic side view of a carrier according to embodiments described herein;
- Fig. 5: shows a schematic side view of a carrier according to embodiments described herein;
- Fig. 6: shows a schematic side view of a carrier according to embodiments described herein;
- Fig. 7: shows a flow chart of a method for carrying a substrate according to embodiments described herein;
- Fig. 8: shows a flow chart of a method for carrying a substrate according to embodiments described herein; and
- Fig. 9: shows a flow chart of a method for carrying a substrate according to embodiments described herein.

### DETAILED DESCRIPTION OF EMBODIMENTS

Reference will now be made in detail to the various embodiments, one or more examples of which are illustrated in the figures. Within the following description of the drawings, the same reference numbers refer to same components. Generally, only the differences with respect to individual embodiments are described. Each example is provided by way of explanation and is not meant as a limitation of the scope. Further, features illustrated or described as part of one embodiment can be used on or in conjunction with other embodiments to yield yet a further embodiment. It is intended that the description includes such modifications and variations.

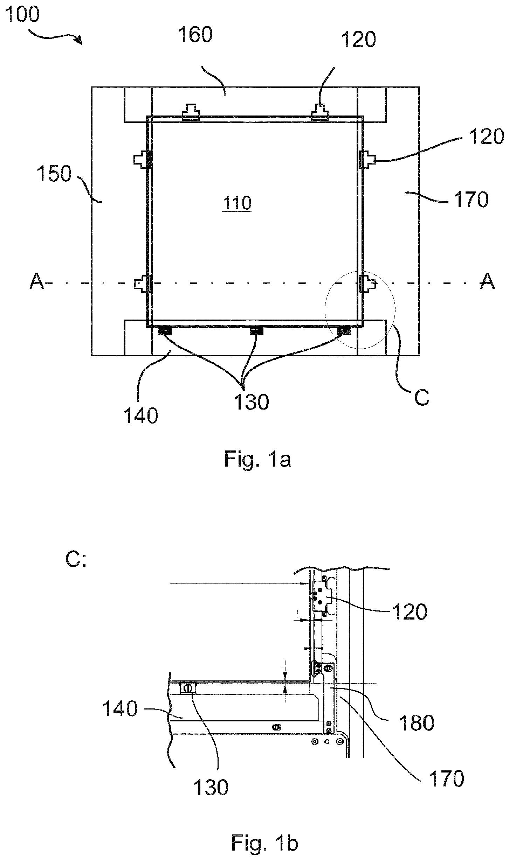

Fig. 1a shows a side view of a carrier 100 holding a substrate 110. The carrier includes a frame having four parts, a bottom part 140, a first side part 150, a top part 160, and a second side part 170. The carrier 100 vertically carries the substrate 110 and includes clamps 120 at the frame parts 150, 160, and 170. The clamps prevent the vertically arranged substrate from falling out of the carrier. At the bottom frame part 140 of the carrier 100, substrate bottom support means 130 are provided, on which the bottom side of the substrate 110 rests.

Generally, the substrates to be coated are held in the carrier and the carrier is moved through the coating system, such as a vacuum coating system. The substrates may, for instance, be coated by a PVD magnetron sputtering process. When carrying substrates for a deposition process, the substrate as well as the carrier are subjected to a high temperature variability. The clamps holding the substrate in the carrier may leave space for thermal expansion between the substrate and the carrier, which may be made of a metal, such as Aluminium and/or Titanium. In an alternative, the clamps touch the substrate but with such a low clamping force that relative movement of the substrate relative to the carrier caused by thermal expansion is allowed.

However, the carrier often has an additional function, namely the above mentioned edge exclusion. The carrier is constructed so as to safely carrying the substrate and acting at the same time as an edge exclusion mask for the outer substrate rim area, which shall not be coated.

Generally, an edge exclusion is desirable when the edge of a substrate should be kept free from deposition material. Keeping an area or edge of the substrate free from deposition material may be the case when only a defined area of the substrate should be coated due to the later application of the coated substrate. For instance, a substrate which will be used as a display part, should have predefined dimensions. Typically, large area substrates are coated using an edge exclusion mask in order to shadow the edge of the substrate and/or to prevent backside coating of the substrate. Using an edge exclusion mask allows for reliable, constant coating on substrates. Substrates having an edge free of deposition material may be further processed.

A precise, reliable and uniform edge exclusion may be desired, which is difficult due to the thermal expansion of the carrier and the substrate during deposition. To this day, (expensive) materials with small thermal expansion are used, such as Titanium and / or special devices to minimize the movement of the substrate inside the carrier. For instance, in known systems, titanium bars are used within the aluminum carrier frame in order to limit the movement of the substrate relative to the carrier due to thermal expansion.

Fig. 1b shows a more detailed view of section C of the carrier as used in known systems of Fig. 1a. In Fig. 1b, the bottom frame part 140, and the second side frame part 170 of carrier 100 carrying the substrate 110 can be seen. A clamp 120 and a substrate bottom support means 130 are also shown in the detailed view of Fig. 1b. For limiting the movement of the substrate 110, a titanium bar 180 is provided in the frame of the carrier 100. For optimizing costs, major parts of the carrier 100 are made from aluminum and the titanium inlay is - due to the different thermal expansion coefficient - used to center the substrate in the carrier frame. During deposition, the carrier and the substrate expand, and, additionally, the substrate being held by the carrier frame, moves as the frame expands. The titanium inlay limits the movement of the substrate caused by the expansion of the aluminum parts of the carrier frame.

The possibility of movement and expansion of the substrate prevents breakage of the substrate, which in some cases may be a thin, sensitive glass substrate. The substrate being movable within a certain area limited by the titanium inlay results in a defined edge exclusion and a secure handling of the substrate.

According to embodiments of a carrier described herein, a movement of the substrate relative to the carrier is prohibited by providing a fixing means for firmly fixing the substrate to the carrier. Embodiments described herein allow for the thermal expansion of the substrate and the carrier irrespective of the material used for the carrier, but firmly fixes the substrate to the carrier at a fixing point. The movement and expansion of the carrier and the substrate of known systems result in the edge area excluded from deposition being greater than desirable for compensating the expansion of the carrier holding the substrate. With embodiments described herein, a smaller edge exclusion area may be realized. Further, carriers according to embodiments described herein, do not incur high costs for a complicated geometry or material inlays of the carrier frame.

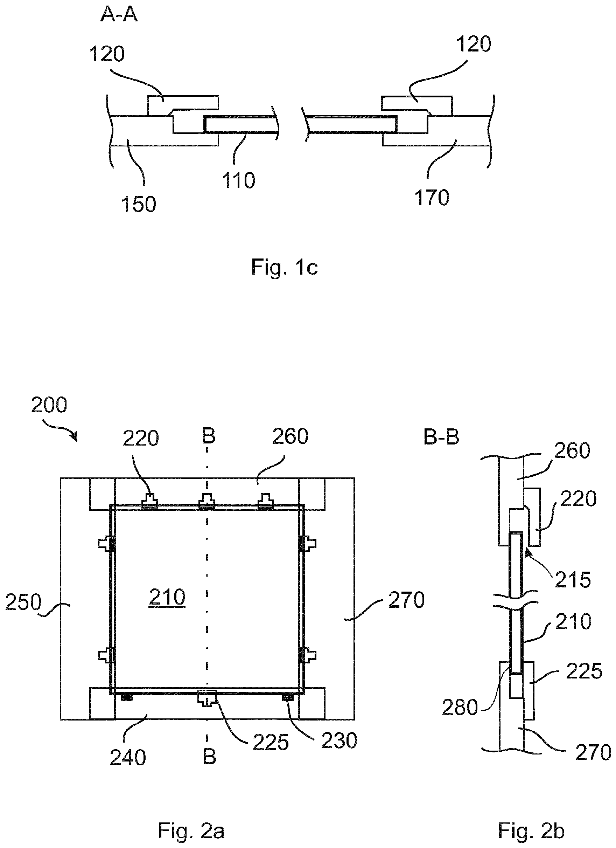

Fig. 2a shows a carrier 200 according to embodiments described herein. The frame of the carrier 200 may be made from aluminum or any other material suitable for being used in a deposition process, such as a PVD process. For instance, the carrier may include, or may substantially be made of stainless steel or titanium. The carrier may include further materials, like PEEK (polyetheretherketone) or PI (polyimide, such as Meldin or Torlon), or at least components of the carrier being made from PEEK or PI. PI materials are for instance useable for even higher temperatures than PEEK and are still vacuum capable.

The carrier carries a substrate 210. According to some embodiments, a substrate as described herein may be made from any material suitable for material deposition. For instance, the substrate may be made from a glass, for instance soda-lime glass, borosilicate glass etc. Further, the substrate may be made from a material selected from the group consisting of metal, polymer, ceramic, compound materials or any other material or combination of materials which can be coated by a deposition process.

The frame of the carrier 200 may include several frame parts, such as bottom frame part 240, first side frame part 250, top frame part 260, and second side frame part 270. The carrier also includes support members 220 for supporting the substrate 210 as well as bottom support members 230 for supporting the substrate 210 at the bottom part. In one example, such as the example shown in Fig. 2a, the support members 230 may be simple support members, such as a rest for the substrate's bottom edge. For instance, the support members may be formed as a projection in the carrier frame part 240 or as a block being made of PEEK or PI fixed to the carrier.

In embodiments described herein, the substrate is vertically held by the substrate carrier, at least during deposition. Vertically holding the substrate may mean, in this context, that the surface to be coated is substantially vertical during deposition. When looking at the coordinate system at the left side of Fig. 2a, it can be seen that the substrate surface to be coated is arranged in the x-y- plane, while the thickness of the substrate extends in the z-direction. As used herein, the bottom part of the frame or of the substrate denotes a part of the frame or of the substrate that includes the lower range of the y-direction values of the frame. For instance, the bottom frame part is the frame part including the lowest y-value of the carrier frame and extending in a horizontal direction. The same definition can be applied to the substrate bottom part. The bottom edge of the substrate may be the edge of the substrate being located at the bottom part of the substrate, such as the horizontal extending edge having the smallest y-direction value compared to the further edges of the substrate.

Furthermore, in the following description, the term "substantially" as used herein may mean that there may be a certain deviation from the characteristic denoted with "substantially." For instance, the term "substantially vertical" refers to a position which may have certain deviations from the exact vertical position, such as a deviation of about 1° to about 15° from the exact vertical position. In some embodiments, the term "substantially rectangular" may mean that the embodiment also includes shapes deviating from the strict rectangular shape to a certain extent. For instance, the angles of the shape denoted with "substantially rectangular" may deviate from a 90° angle for about 1° to about 10°.

According to embodiments described herein, the carrier 200 includes a fixing means 225 for firmly fixing the substrate to the carrier. In the embodiment shown in Fig. 2a, one single fixing means 225 is provided for firmly fixing the substrate 210 to the carrier 200. The fixing means 225 is located in a center region of the bottom frame part, as will be explained in detail below. The fixing means 225 firmly fixes the substrate in the center of the substrate's bottom edge and helps optimizing the edge exclusion of the carrier. The fixing means 225 may provide a fixing point for the substrate. From the fixing point, the substrate is still able to expand in all directions in relation to the carrier frame, and is prevented from breaking due to stress caused by movement limitations. Providing a fixing point spares space within the carrier pouch.

Carriers according to embodiments described herein help optimizing the edge exclusion for low temperature processes (such as processes ≤ 130°C) as well as high temperature processes (up to 360°C). In the embodiment shown in Fig. 2a, the substrate is coupled to the carrier at one single point in the center region of the bottom frame part due to the fixing point provided by the one single fixing means. As described above, embodiments of the carrier described herein include one single fixing means for firmly fixing the substrate to the carrier, which should be understood as exactly one fixing means for firmly fixing the substrate, whereas further support members may be provided, which do not firmly fix the substrate but hold the substrate in a way allowing for movement. Allowing for movement in the support members not firmly fixing the substrate to the carrier may be achieved by leaving a space in the support member or by choosing the force in the support member (such as a clamp force in a clamp) so low that a movement of the substrate is still possible.

The difference between the support members 220 and the fixing means 225 can be seen in Fig. 2b. Fig. 2b shows a (slightly enlarged) sectional view of the carrier 200 shown in Fig. 2a, in particular a sectional view along line B-B as indicated in Fig. 2a. The fixing means 225 in the embodiment shown in Fig. 2a and 2b may be a clamp, which firmly fixes the substrate 210 to the carrier, or at least the carrier bottom frame part 240. Compared thereto, the support members 220, exemplarily provided at sides 250, 260, and 270 of the carrier 200, leave space 215 between the support member 220 and the substrate 210 for allowing a movement of the substrate 210. In an alternative, the support members may touch the substrate but with such a low force exerted on the substrate that a relative movement of the substrate caused by thermal expansion is still allowed within the support member.

For a comparison to the system of Fig. 1a, a sectional view of Fig. 1a along line A-A is shown in Fig. 1c. The clamps 120 of the carrier 100 shown in Fig. 1c leave space for the above described movement between substrate and carrier.

In some embodiments, the proven design from known support members being formed as a clamp may be used to produce the fixing means according to embodiments described herein. For instance, a stronger spring and a geometry adapted to the stronger spring may be used in known clamps in order to provide the force for firmly fixing the substrate. Using stronger springs may spare costs and is easy to realize, although the movement of the substrate is sufficiently limited or prevented.

It should be understood that the term "firmly fixing" refers to a function preventing a movement of the substrate relative to the carrier frame at least at the fixing point provided by the fixing means. The fixing means may be described as securely or solidly fixing the substrate at the fixing point to the carrier frame. The substrate and the carrier are coupled at the fixing point by the fixing means. According to some embodiments, the fixing means may be a clamp, such as a clamp including a spring for firmly fixing the substrate. For instance, the fixing means may be adapted for firmly fixing the substrate to the carrier during deposition, and for releasing the substrate after the deposition process is completed. In some embodiments, the fixing means may be able to take several positions, one of which may provide the above described firm fixing of the substrate. Further positions may be provided by the fixing means, such as an open position, or a position allowing movement of the substrate.

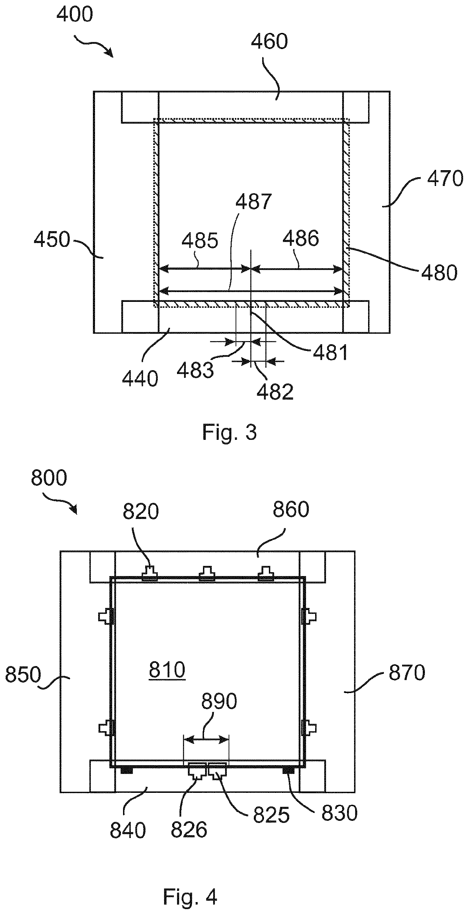

Fig. 3 shows an embodiment of a carrier 400. The carrier 400 shown in Fig. 3 is illustrated without a substrate, but with a substrate receiving surface 480 running around the inner circumference of the carrier 400. The carrier includes frame parts 440, 450, 460, and 470. As described above with respect to Figs. 2a and 2b, the fixing means are provided at a center region of the carrier's bottom frame part, such as bottom frame part 440 in Fig. 3. Generally, the bottom part of the substrate receiving surface 480 is to be understood as the part of the substrate receiving surface 480 being located on the bottom frame part of the carrier.

In some embodiments, which may be combined with other embodiments described herein, the center region of the bottom frame part corresponds to a center region of the bottom part of the substrate receiving surface. For instance, the substrate receiving surface of the carrier may be the surface which the substrate is in contact with whilst being carried by the carrier. Referring back to Fig. 2b, the substrate receiving surface is shown in the embodiment as substrate receiving surface 280. In Fig. 2b, it can be seen that the substrate is in contact with the substrate receiving surface 280. It should be understood that in Fig. 3, the hatched area 480 stands substantially in contact with the substrate, when a substrate is carried by the carrier 400.

In one example, the substrate receiving surface may act as an edge exclusion for covering the circumference of the substrate. The part of the substrate being in contact with the substrate carrier 400 is not coated during the coating process. In some embodiments, an edge exclusion may cover from about 1‰ to about 5% of the area of the substrate, typically between about 4‰ to about 4% and even more typically between about 1% and about 3% of the area of the substrate. It should be understood (and can be seen in Fig. 3) that the area of the substrate covered by the carrier acting as an edge exclusion mask is located at the periphery of the substrate.

In Fig. 3, the center of the bottom side of the substrate receiving surface 480 is denoted with 481. The center 481 of the bottom part of the substrate receiving surface 480 may be defined as the middle point of the bottom part of the substrate receiving surface 480. Also, the center 481 of the bottom side of the substrate receiving surface 480 may be defined as a point which has substantially the same distance to the substrate receiving surface of carrier side frame parts 450 and 470, respectively. For instance, distances 485 and 486 as shown in Fig. 3 may have substantially the same values.

According to some embodiments described herein, the center region of the bottom frame part may be defined by the center region of the bottom part of the substrate receiving surface 480.

The center region as described herein should be understood as a region including the center point, such as the center region of the substrate receiving surface 480 may include center 481. Further, the center region of the bottom part of the substrate receiving surface 480 may include a certain area around the center 481. In one embodiment, which may be combined with other embodiments described herein, the center region of the bottom part of the substrate receiving surface 480 may include the center 481 of the substrate receiving surface 480 at the bottom frame part 440 of the carrier 400 and a deviation of about 15% of the length of the bottom part of the substrate receiving surface in each direction. In Fig. 3, the distances 482 and 483 indicate a distance from the center point 481 of about 15% of the total length 487 of the substrate receiving surface 480 of the bottom frame part 440, respectively. Distances 482 and 483 together indicate the length of the center region of the substrate receiving surface 480.

According to some embodiments, the total length of the substrate receiving surface 480 of the bottom frame part 440 as used herein may be defined as including the extension of the substrate receiving surface 480 at the bottom frame part 440 in x-direction.

As described above, the center region of the bottom frame part 440 may correspond to a center region of the bottom part of the substrate receiving surface 480. However, it should be noted that in the case that the carrier frame does not have a substantially symmetric shape (such as a shape shown in Fig. 3, having an extended left side of the bottom frame part 440), the center region of the bottom frame part may depend on the center region of the bottom part of the substrate receiving surface. However, in some embodiments, the substrate may be firmly fixed to the carrier 400 at the center region of the substrate receiving surface 480 of the bottom frame part 440.

According to some embodiments, the carrier may be adapted for carrying more than one substrate. In the case that the carrier is adapted for carrying more than one substrate, the carrier may include a substrate receiving surface for each of the substrates and a fixing means being located as described above for each substrate.

In some embodiments, the fixing point provided by the fixing means (not shown in Fig. 3) may be located at the center point 481 of the bottom part of the substrate receiving surface of the carrier frame.

Fig. 4 shows a carrier 800 according to embodiments described herein. The carrier includes a bottom frame part 840, a first side frame part 850, a top frame part 860, and a second side frame part 870. The carrier 800 vertically holds substrate 810. Further, the carrier includes support members 820 for supporting, but not firmly fixing the substrate 810. The support members 820 are exemplarily located at the first side frame part 850, the top frame part 860, and the second side frame part 870. Also, bottom support members 830 may be provided for supporting the bottom edge of the substrate 810.

In the embodiment shown in Fig. 4, two fixing means 825, 826 are provided in the center region 890 of the bottom frame part 840. The center region may be a center region as discussed in detail above with respect to Fig. 3. For instance, the center region in which the two fixing means 825, 826 are located may range from the center point of the bottom frame part to about 15% of the length of the bottom frame part in each direction. In some embodiments, the fixing means 825, 826 are arranged to the left and to the right from the center point of the bottom frame part.

In some embodiments, the center region 890 of the bottom frame part 840 may depend on the center region of the substrate receiving surface, as explained above with respect to Fig. 3. The fixing means 825, 826 may be located in a region including the center point of the bottom side of the substrate receiving surface and 15% of the length of the substrate receiving surface in each direction.

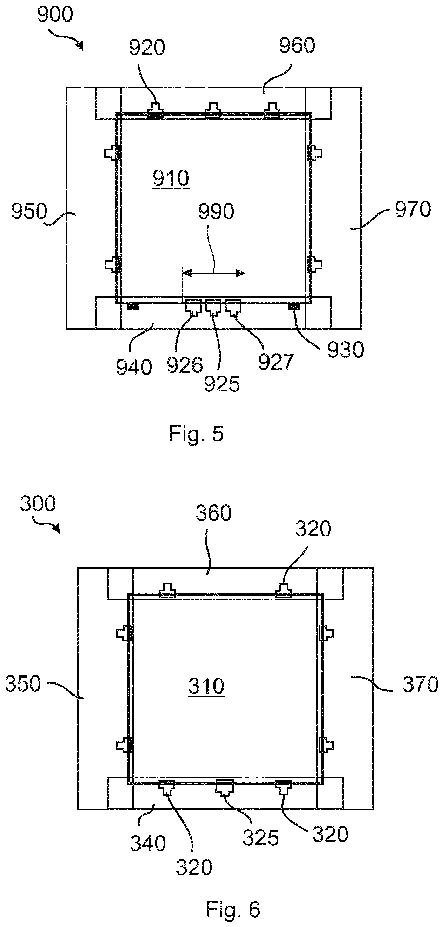

Fig. 5 shows an embodiment of a carrier 900 including three fixing means 925, 926, and 927 at the center region 990 of the bottom frame part 940. The carrier 900 further includes a bottom frame part 940, a first side frame part 950, a top frame part 960, and a second side frame part 970. The carrier 900 vertically holds substrate 910 and may include support members 920 and bottom support members 930. Generally, the same applies as discussed with respect to Figs. 3 and 4. In particular, the above definition of the center region of the bottom frame part may be applied to the center region 990 of the bottom frame part 940 of the carrier 900. Also, the center region 990 may depend on the center region of a bottom part of a substrate receiving surface as discussed above.

According to some embodiments, one of the three fixing means 925, 926, and 927 may be located as a middle fixing means at the center point of the bottom frame part or the center point of the bottom part of the substrate receiving surface. Two of the three fixing means may be located beside the middle fixing means within the center region 990 of the bottom frame part 940 or the center region of the bottom part of the substrate receiving surface.

In the case that more than one single fixing means are provided, the fixing point provided by the fixing means may be understood as the resulting force application point of the two or three fixing means in the center region of the bottom frame part of the carrier frame. In other words, the fixing point depends on the resulting action line of the forces applied by the fixing means.

Fig. 6 shows an embodiment of a carrier according to embodiments described herein. While Figs. 2a and 2b show support members 230 at the bottom frame part 240 of the carrier frame, carrier 300 includes clamps 320 at the bottom frame part 340. The clamps 320 at the bottom frame part 340 of the carrier 300 help in holding the substrate in a relative position, while not fixing the substrate 310. In the embodiment shown in Fig. 6, the substrate is fixed by fixing means 325, which may be a fixing means as described above.

In the embodiments shown in the figures, the number of clamps is a mere example and should not be understood as limiting the embodiments described herein. The number of support members per carrier may be typically between about 2 and about 10, more typically between about 3 and about 8, and even more typically between about 3 and 6.

For ensuring a firm fixing of the substrate by the fixing means, the fixing means are adapted to the frame and allow for firmly fixing a substrate having a thickness of typically between about 0.2 mm to about 6 mm, more typically between 0.3 mm to about 2 mm, and even more typically between about 0.3 mm to about 1.5 mm. In one example, the thickness may be up to 1.2 mm. The fixing means in the form of a clamp may also be equipped with damping elements for securely and reliably fixing the substrate without damaging it.

In some embodiments, the fixing means may include a clamp including a spring. The spring force of the spring exerted to the substrate for firmly fixing the substrate to the carrier may typically be between 15 N and about 25 N, more typically between about 16 N and about 23 N, and even more typically between about 17 N and about 20 N. In one example, the spring force applied fixing means according to embodiments described herein is about 17 N. In embodiments, in which more than one fixing means is provided for firmly fixing the substrate (such as the embodiments shown in Figs. 4 and 5), each fixing means may have a spring force in the above described range.

According to some embodiments, the substrates, for which the carriers and methods according to embodiments described herein are provided, may have a size of typically about 1.4 m² to about 8 m², more typically about 2 m² to about 9 m² or even up to 12 m². For instance, a substrate may be GEN 5, which corresponds to about 1.4 m² substrates (1.1 m x 1.25 m), GEN 7.5, which corresponds to about 4.29 m² substrates (1.95 m x 2.2 m), GEN 8.5, which corresponds to about 5.7m² substrates (2.2 m x 2.5 m), or even GEN 10, which corresponds to about 8.7 m² substrates (2.85 m x 3.05 m). Even larger generations such as GEN 11 and GEN 12 and corresponding substrate areas can similarly be implemented. According to some embodiments, substrates may have a size of about 300 mm x 400 mm, 305 mm x 356 mm, 320 mm x 650 mm, 356 mm x 356mm, 356 mm x 406 mm, 370mm x 470 mm, 400 mm x500 mm, 550 mm x 650 mm, 550 mm x 670 mm, 620 mm x 750mm, 650 mm x 750 mm, 670 mm x 830 mm, 680 mm x 880 mm, or 730 mm x 920 mm.

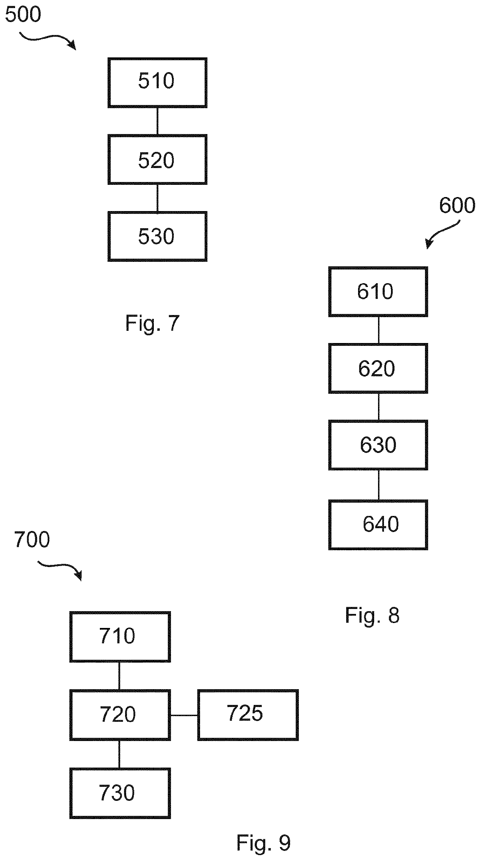

According to some embodiments, a method is described. An embodiment of a method described herein is shown as a flow chart in Fig. 7. The method 500 for carrying a substrate during a deposition process includes, at block 510, carrying the substrate with a carrier including a frame for vertically holding the substrate. The carrier frame may be a carrier frame as described with respect to Figs. 2 to 6. The frame of the carrier may have a substantially rectangular shape with a bottom frame part.

The method 500 includes at block 520 firmly fixing the substrate to the carrier. The firm fixing of the substrate to the carrier, or the coupling of the substrate to the carrier, which may for instance take place at a fixing point, may be performed with a, and preferably with one single fixing means at the bottom edge of the substrate. According to some embodiments, the fixing means may be located at a center region of the bottom frame part of the carrier. In some embodiments, which are for instance described in detail above, the one single fixing means may fix the substrate to the carrier at a center region of a substrate receiving surface of the carrier.

According to some embodiments, the substrate is firmly fixed to the carrier at exactly one single fixing point provided by the fixing means. From the fixing point, the substrate may still expand, but the movement of the substrate relative to the carrier is prevented.

In block 530, embodiments of the herein described method 500 include supporting the substrate in the carrier with one or more support members without firmly fixing the substrate with the support members. The support members may be clamps, which allow the substrate to move within a defined space provided by the carrier and the clamps. In some embodiments, the support members may be provided at each side of the carrier frame. In particular, the support members may be located at every side of the carrier, such as (referring back to Fig. 2) on the bottom side frame part 240, the left side frame part 250, the top side frame part 260, and the right side frame part 270.

According to some embodiments, the fixing means may be fixing means as described above in detail with respect to Figs. 2 to 6. For instance, the fixing means may be a clamp exerting a defined force on the substrate so as to firmly fix the substrate to the carrier. In one example, the fixing means may include a spring being adapted to the parameters of the carrier and the substrate to be carried. The fixing means may be adapted to apply a force to the substrate, which is high enough for firmly fixing it, and which is low enough so as to not damage the substrate. In some embodiments, the force used to firmly fix the substrate may be provided by more than one fixing means, such as two or three fixing means, in the center region of the bottom frame part.

Using a respectively adapted spring in the fixing means in a carrier according to embodiments described herein, is a simple means for proving the force for firmly fixing the substrate to the carrier, which does not cause high costs. Compared to a titanium inlay, as for instance described with respect to Fig. 1b, the carrier according to embodiments described herein, may be produced in a very cost efficient way, while keeping the weight of the carrier also low.

An embodiment of method 600 is shown in Fig. 8. According to some embodiments, blocks 610, 620, and 630 may correspond to blocks 510, 520, and 530 of method 500, respectively. Method 600 further includes block 640 including covering the edge of the substrate with the carrier frame. By covering the edge of the substrate with the carrier frame, a mask may be provided by the frame resulting in an edge exclusion as described above. For instance, the edge exclusion function of the carrier frame may depend on the substrate receiving surface of the carrier frame.

Fig. 9 shows an embodiment of a method 700. The method 700 includes blocks 710, 720, and 730, which may correspond to blocks 510, 520, 530, or also to blocks 610, 620, 630, respectively. In method 700, wherein firmly fixing the substrate at the fixing point includes in block 725 preventing a movement of the substrate at the fixing point provided by the fixing means relative to the carrier during operation in the deposition chamber. By firmly fixing the substrate to the carrier, the substrate is coupled to the carrier so that a relative movement of the substrate to the carrier is limited. Nevertheless, the substrate as well as the carrier are still able to expand independently from one another.

According to some embodiments described herein, the carrier frame used in a method described herein includes a substrate receiving surface, as exemplarily shown as substrate receiving surface 480. In some embodiments, the center region of the bottom frame part corresponds to a center region of the substrate receiving surface of the bottom frame part. However, in some embodiments, the substrate may be firmly fixed to the carrier at the center region of the substrate receiving portion of the bottom frame part.

Apart from the described effects achieved by the carrier according to embodiments described herein, several further desirable effects are linked to the use of a carrier as described herein. For instance, the edge exclusion can be optimized with a carrier according to embodiments described herein by providing a small, defined, but still existent area to be excluded from coating. Further, costs and expensive materials can be spared by using the fixing means in a carrier, according to embodiments, compared to an expensive titanium inlay.

According to some embodiments, a further effect of the carrier is a reduction of scratches on the substrate rim due to fewer possibilities for the substrate to move inside the carrier pouch. By firmly fixing the substrate at one fixing point, the substrate is firmly held in the carrier and the location of the substrate can accurately be defined. Accurately defining the substrate's position within the carrier helps in increasing the product quality.

A further effect of the carrier, according to embodiments described herein, is that the edge exclusion can be designed smaller (inter alia due to the increased precision), which increases the overall process efficiency. Also, the number of parts used in the carrier is decreased, because the titanium inlay may be omitted compared to known systems. Keeping the number of used parts small can further be emphasized by using substantially known clamp designs for the fixing means and increasing the clamp force.

While preventing movement of the substrate within the carrier, and at the same time allowing an expansion of the substrate in each direction from the fixing point, the risk of substrate breakage may be reduced in carriers according to embodiments described herein,

While the foregoing is directed to some embodiments, other and further embodiments may be devised without departing from the basic scope thereof, and the scope thereof is determined by the claims that follow.

## Claims

1. A carrier (200; 300; 400) for carrying a substrate (210; 310) in a deposition chamber, comprising:
a frame (240; 250; 260; 270; 340; 350; 360; 370; 440; 450; 460; 470) for vertically holding the substrate (210; 310), wherein the frame has a substantially rectangular shape with a bottom frame part (240; 340; 440);
a fixing means (225; 325) for firmly fixing the substrate (210; 310) to the carrier (200; 300; 400), wherein the fixing means (225; 325) is located in a center region of the bottom frame part (240; 340; 440); and
one or more support members (220; 230; 320) for supporting but not firmly fixing the substrate (210; 310).

2. The carrier according to claim 1, wherein the carrier comprises one single fixing means (225; 325) in the center region of the bottom frame part (240; 340; 440) for firmly fixing the substrate (210; 310) to the carrier (200; 300; 400).

3. The carrier according to any of claims 1 to 2, wherein the one or more support members (220; 230; 320) are positioned at the bottom frame part (240; 340) of the frame (240; 250; 260; 270; 340; 350; 360; 370; 440; 450; 460; 470).

4. The carrier according to any of claims 1 to 3, wherein the fixing means (225; 325) comprises a clamp.

5. The carrier according to claim 4, wherein the clamp comprises a spring.

6. The carrier according to any of claims 1 to 5, wherein the frame (240; 250; 260; 270; 340; 350; 360; 370; 440; 450; 460; 470) and the fixing means (225; 325) are adapted for firmly fixing the substrate (210; 310) having a thickness in a range of about 0.3 mm to about 1.5 mm.

7. The carrier according to any of claims 1 to 6, wherein the fixing means (225; 325) is adapted to prevent a movement of the substrate (210; 310) at a fixing point (481) provided by the fixing means (225; 325) relative to the carrier (200; 300; 400) during operation in the deposition chamber.

8. The carrier according to any of claims 1 to 7, wherein the frame (240; 250; 260; 270; 340; 350; 360; 370; 440; 450; 460; 470) comprises a substrate receiving surface (480), wherein the center region of the bottom frame part (240; 340; 440) corresponds to a center region (481; 482) of the bottom part of the substrate receiving surface (480).

9. The carrier according to any of claims 1 to 7, wherein the frame (240; 250; 260; 270; 340; 350; 360; 370; 440; 450; 460; 470) comprises a substrate receiving surface (480), and wherein the center region of the bottom frame part (240; 340; 440) corresponds to a center region of the bottom part of the substrate receiving surface (480) including the center (481) of the bottom part of the substrate receiving surface (480) and a deviation of about 15% of the length (487) of the substrate receiving surface (480) in each direction.

10. The carrier according to any of claims 1 to 9, wherein the frame (240; 250; 260; 270; 340; 350; 360; 370; 440; 450; 460; 470) is adapted to provide an edge exclusion for the substrate (210; 310).

11. Method for carrying a substrate (210; 310) during a deposition process in a deposition chamber with a carrier (200; 300; 400) comprising a frame (240; 250; 260; 270; 340; 350; 360; 370; 440; 450; 460; 470) for vertically holding the substrate (210; 310), wherein the frame has a substantially rectangular shape with a bottom frame part (240; 340; 440), the method comprising:
firmly fixing the substrate (210; 310) to the carrier (200; 300; 400) with a fixing means (225; 325) at a center region of the of the bottom frame part, and
supporting the substrate (210; 310) in the carrier (200; 300; 400) with one or more support members (220; 230; 320) without firmly fixing the substrate with the support members.

12. The method according to claim 11, wherein firmly fixing the substrate (210; 310) to the carrier (200; 300; 400) comprises firmly fixing the substrate (210; 310) to the carrier (200; 300; 400) with one single fixing means (225; 325).

13. The method according to any of claims 11 to 12, wherein firmly fixing the substrate (210; 310) comprises preventing a movement of the substrate (210; 310) at a fixing point provided by the fixing means (225; 325) relative to the carrier (200; 300; 400) during operation in the deposition chamber.

14. The method according to any of claims 11 to 13,further comprising covering the edge of the substrate (210) by the frame (240; 250; 260; 270; 340; 350; 360; 370; 440; 450; 460; 470).

15. The method according to any of claims claim 11 to 14, wherein the frame (240; 250; 260; 270; 340; 350; 360; 370; 440; 450; 460; 470) comprises a substrate receiving surface (480), wherein the center region of the bottom frame part (240; 340; 440) corresponds to a center region of the substrate receiving surface (480).

## Patentansprüche

1. Träger (200; 300; 400) zum Tragen eines Substrats (210; 310) in einer Abscheidungskammer, Folgendes umfassend:
einen Rahmen (240; 250; 260; 270; 340; 350; 360; 370; 440; 450; 460; 470) zum vertikalen Halten des Substrats (210; 310), wobei der Rahmen eine im Wesentlichen rechteckige Form mit einem unteren Rahmenteil (240; 340; 440) hat;
eine Fixiereinrichtung (225; 325) zum festen Fixieren des Substrats (210; 310) am Träger (200; 300; 400), wobei die Fixiereinrichtung (225; 325) in einem Mittenbereich des unteren Rahmenteils (240; 340; 440) angeordnet ist; und
eine oder mehrere Halterungsteile (220; 230; 320), um das Substrat (210; 310) zu haltern, aber nicht fest zu fixieren.

2. Träger nach Anspruch 1, wobei der Träger eine einzelne Fixiereinrichtung (225; 325) im Mittenbereich des unteren Rahmenteils (240; 340; 440) zum festen Fixieren des Substrats (210; 310) am Träger (200; 300; 400) umfasst.

3. Träger nach einem der Ansprüche 1 bis 2, wobei sich das eine oder die mehreren Halterungsteil/e (220; 230; 320) am unteren Rahmenteil (240; 340) des Rahmens (240; 250; 260; 270; 340; 350; 360; 370; 440; 450; 460; 470) befindet/befinden.

4. Träger nach einem der Ansprüche 1 bis 3, wobei die Fixiereinrichtung (225; 325) eine Klemme umfasst.

5. Träger nach Anspruch 4, wobei die Klemme eine Feder umfasst.

6. Träger nach einem der Ansprüche 1 bis 5, wobei der Rahmen (240; 250; 260; 270; 340; 350; 360; 370; 440; 450; 460; 470) und die Fixiereinrichtung (225; 325) dazu angepasst sind, das Substrat (210; 310) fest zu fixieren, das eine Dicke im Bereich von ca. 0,3 mm bis ca. 1,5 mm hat.

7. Träger nach einem der Ansprüche 1 bis 6, wobei die Fixiereinrichtung (225; 325) dazu angepasst ist, eine Bewegung des Substrats (210; 310) an einem durch die Fixiereinrichtung (225; 325) bereitgestellten Fixierpunkt (481) in Bezug auf den Träger (200; 300; 400) während des Betriebs in der Abscheidungskammer zu verhindern.

8. Träger nach einem der Ansprüche 1 bis 7, wobei der Rahmen (240; 250; 260; 270; 340; 350; 360; 370; 440; 450; 460; 470) eine Substrataufnahmefläche (480) hat, wobei der Mittenbereich des unteren Rahmenteils (240; 340; 440) einem Mittenbereich (481; 482) des unteren Teils der Substrataufnahmefläche (480) entspricht.

9. Träger nach einem der Ansprüche 1 bis 7, wobei der Rahmen (240; 250; 260; 270; 340; 350; 360; 370; 440; 450; 460; 470) eine Substrataufnahmefläche (480) hat, und wobei der Mittenbereich des unteren Rahmenteils (240; 340; 440) einem Mittenbereich (481; 482) des unteren Teils der Substrataufnahmefläche (480) einschließlich der Mitte (481) des unteren Teils der Substrataufnahmefläche (480) und einer Abweichung von ca. 15% der Länge (487) der Substrataufnahmefläche (480) in jeder Richtung entspricht.

10. Träger nach einem der Ansprüche 1 bis 9, wobei der Rahmen (240; 250; 260; 270; 340; 350; 360; 370; 440; 450; 460; 470) dazu angepasst ist, eine Randausschließung für das Substrat (210; 310) bereitzustellen.

11. Verfahren zum Tragen eines Substrats (210; 310) während eines Abscheidungsprozesses in einer Abscheidungskammer mit einem Träger (200; 300; 400), der einen Rahmen (240; 250; 260; 270; 340; 350; 360; 370; 440; 450; 460; 470) zum vertikalen Halten des Substrats (210; 310) hat, wobei der Rahmen eine im Wesentlichen rechteckige Form mit einem unteren Rahmenteil (240; 340; 440) hat, wobei das Verfahren umfasst:
festes Fixieren des Substrats (210; 310) am Träger (200; 300; 400) mit einer Fixiereinrichtung (225; 325) in einem Mittenbereich des unteren Rahmenteils, und Haltern des Substrats (210; 310) im Träger (200; 300; 400) mit einem oder mehreren Halterungsteil/en (220; 230; 320), ohne das Substrat mit den Halterungsteilen fest zu fixieren.

12. Verfahren nach Anspruch 11, wobei das feste Fixieren des Substrats (210; 310) am Träger (200; 300; 400) umfasst, das Substrat (210; 310) mit einer einzelnen Fixiereinrichtung (225; 325) fest am Träger (200; 300; 400) zu fixieren.

13. Verfahren nach einem der Ansprüche 11 bis 12, wobei das feste Fixieren des Substrats (210; 310) umfasst, eine Bewegung des Substrats (210; 310) an einem durch die Fixiereinrichtung (225; 325) bereitgestellten Fixierpunkt in Bezug auf den Träger (200; 300; 400) während des Betriebs in der Abscheidungskammer zu verhindern.

14. Verfahren nach einem der Ansprüche 11 bis 13, darüber hinaus umfassend, den Rand des Substrats (210) mit dem Rahmen (240; 250; 260; 270; 340; 350; 360; 370; 440; 450; 460; 470) abzudecken.

15. Verfahren nach einem der Ansprüche 11 bis 14, wobei der Rahmen (240; 250; 260; 270; 340; 350; 360; 370; 440; 450; 460; 470) eine Substrataufnahmefläche (480) hat, wobei der Mittenbereich des unteren Rahmenteils (240; 340; 440) einem Mittenbereich (481; 482) der Substrataufnahmefläche (480) entspricht.

## Revendications

1. Porteur (200 ; 300 ; 400) destiné à porter un substrat (210 ; 310) dans une chambre de dépôt, comprenant :
un cadre (240 ; 250 ; 260 ; 270 ; 340 ; 350 ; 360 ; 370 ; 440 ; 450 ; 460 ; 470) destiné à maintenir verticalement le substrat (210 ; 310), sachant que le cadre a une forme sensiblement rectangulaire avec une partie de cadre de fond (240 ; 340 ; 440) ;
un moyen de fixation (225 ; 325) destiné à fixer fermement le substrat (210 ; 310) au porteur (200 ; 300 ; 400), sachant que le moyen de fixation (225 ; 325) est situé dans une région centrale de la partie de cadre de fond (240 ; 340 ; 440) ; et
un ou plusieurs éléments de support (220 ; 230 ; 320) destinés à supporter, mais sans fixer fermement, le substrat (210 ; 310).

2. Le porteur selon la revendication 1, sachant que le porteur comprend un seul moyen de fixation (225 ; 325) dans la région centrale de la partie de cadre de fond (240 ; 340 ; 440) pour fixer fermement le substrat (210 ; 310) au porteur (200 ; 300 ; 400).

3. Le porteur selon l'une quelconque des revendications 1 à 2, sachant que l'un ou les plusieurs éléments de support (220 ; 230 ; 320) sont positionnés au niveau de la partie de cadre de fond (240 ; 340) du cadre (240 ; 250 ; 260 ; 270 ; 340 ; 350 ; 360 ; 370 ; 440 ; 450 ; 460 ; 470).

4. Le porteur selon l'une quelconque des revendications 1 à 3, sachant que le moyen de fixation (225 ; 325) comprend une attache.

5. Le porteur selon la revendication 4, sachant que l'attache comprend un ressort.

6. Le porteur selon l'une quelconque des revendications 1 à 5, sachant que le cadre (240 ; 250 ; 260 ; 270 ; 340 ; 350 ; 360 ; 370 ; 440 ; 450 ; 460 ; 470) et le moyen de fixation (225 ; 325) sont aptes à fixer fermement le substrat (210 ; 310) ayant une épaisseur comprise dans une plage d'environ 0,3 mm à environ 1,5 mm.

7. Le porteur selon l'une quelconque des revendications 1 à 6, sachant que le moyen de fixation (225 ; 325) est apte à empêcher un mouvement du substrat (210 ; 310) à un point de fixation (481) assuré par le moyen de fixation (225 ; 325) par rapport au porteur (200 ; 300 ; 400) pendant le fonctionnement dans la chambre de dépôt.

8. Le porteur selon l'une quelconque des revendications 1 à 7, sachant que le cadre (240 ; 250 ; 260 ; 270 ; 340 ; 350 ; 360 ; 370 ; 440 ; 450 ; 460 ; 470) comprend une surface de réception de substrat (480), sachant que la région centrale de la partie de cadre de fond (240 ; 340 ; 440) correspond à une région centrale (481 ; 482) de la partie de fond de la surface de réception de substrat (480).

9. Le porteur selon l'une quelconque des revendications 1 à 7, sachant que le cadre (240 ; 250 ; 260 ; 270 ; 340 ; 350 ; 360 ; 370 ; 440 ; 450 ; 460 ; 470) comprend une surface de réception de substrat (480), et sachant que la région centrale (481 ; 482) de la partie de cadre de fond (240 ; 340 ; 440) correspond à une région centrale de la partie de fond de la surface de réception de substrat (480) incluant le centre (481) de la partie de fond de la surface de réception de substrat (480) et un écart d'environ 15% de la longueur (487) de la surface de réception de substrat (480) dans chaque direction.

10. Le porteur selon l'une quelconque des revendications 1 à 9, sachant que le cadre (240 ; 250 ; 260 ; 270 ; 340 ; 350 ; 360 ; 370 ; 440 ; 450 ; 460 ; 470) est apte à assurer une exclusion de bord pour le substrat (210 ; 310).

11. Procédé destiné à porter un substrat (210 ; 310) pendant un processus de dépôt dans une chambre de dépôt au moyen d'un porteur (200 ; 300 ; 400) comprenant un cadre (240 ; 250 ; 260 ; 270 ; 340 ; 350 ; 360 ; 370 ; 440 ; 450 ; 460 ; 470) destiné à maintenir verticalement le substrat (210 ; 310), sachant que le cadre a une forme sensiblement rectangulaire avec une partie de cadre de fond (240 ; 340 ; 440), le procédé comprenant :
la fixation ferme du substrat (210 ; 310) au porteur (200 ; 300 ; 400) avec un moyen de fixation (225 ; 325) au niveau d'une région centrale de la partie de cadre de fond, et
le fait de supporter le substrat (210 ; 310) dans le porteur (200 ; 300 ; 400) avec un ou plusieurs éléments de support (220 ; 230 ; 320) sans fixer fermement le substrat avec les éléments de support.

12. Le procédé selon la revendication 11, sachant que la fixation ferme du substrat (210 ; 310) au porteur (200 ; 300 ; 400) comprend la fixation ferme du substrat (210 ; 310) au porteur (200 ; 300 ; 400) avec un seul moyen de fixation (225 ; 325).

13. Le procédé selon l'une quelconque des revendications 11 à 12, sachant que la fixation ferme du substrat (210 ; 310) comprend le fait d'empêcher un mouvement du substrat (210 ; 310) à un point de fixation assuré par le moyen de fixation (225 ; 325) par rapport au porteur (200 ; 300 ; 400) pendant le fonctionnement dans la chambre de dépôt.

14. Le procédé selon l'une quelconque des revendications 11 à 13, comprenant en outre le fait de couvrir le bord du substrat (210) moyennant le cadre (240 ; 250 ; 260 ; 270 ; 340 ; 350 ; 360 ; 370 ; 440 ; 450 ; 460 ; 470).

15. Le procédé selon l'une quelconque des revendications 11 à 14, sachant que le cadre (240 ; 250 ; 260 ; 270 ; 340 ; 350 ; 360 ; 370 ; 440 ; 450 ; 460 ; 470) comprend une surface de réception de substrat (480), sachant que la région centrale de la partie de cadre de fond (240 ; 340 ; 440) correspond à une région centrale (481 ; 482) de la surface de réception de substrat (480).
